# EUROPEAN PATENT SPECIFICATION

(11) **EP 0 409 214 B1**
(45) Date of publication and mention of the grant of the patent: **13.12.1995**
(21) Application number: 90113792.7
(22) Date of filing: 18.07.1990
(51) Int. Cl.: H02H 5/04

(54) **Overheating detection circuit for use with a power integrated circuit**
Übertemperatur-Detektorschaltung zur Verwendung mit einer integrierten Leistungsschaltung
Circuit de détection de surchauffe pour l'utilisation dans un circuit intégré de puissance

(30) Priority: 19.07.1989 JP 186951/89; 05.03.1990 JP 53086/90
(43) Date of publication of application: 23.01.1991
(60) Divisional application: 94105190.6
(73) Proprietor: FUJI ELECTRIC CO., LTD., Kawasaki-shi Kanagawa 210 (JP)
(72) Inventor: Fujihira, Tatsuhiko, c/o Fuji Electric Co., Ltd., Kawasaki-shi, Kanagawa (JP)
(74) Representative: Grünecker, Kinkeldey, Stockmair & Schwanhäusser Anwaltssozietät

(56) References cited:
- EP-A- 0 240 807
- RCA TECHNICAL NOTES. no. 1270, 02 March 1981, PRINCETON US pages 1 - 3; O.H. Schade: "Thermal Shutdown Circuitry"
- TECHNICAL DIGEST - WESTERN ELECTRIC. no. 72, October 1983, NEW YORK US pages 15 - 16; D.M.Embree: "Thermal Shutdown Circuit"

## Description

The present invention relates to an overheating detection circuit for use with a power integrated circuit (IC) and, more specifically to an overheating detection circuit comprising a simple circuit construction which may be formed in the same substrate as that of a power IC, and which can produce a large output signal in response to a detection of a temperature within a range of detection temperatures.

Because power devices are used under high voltage and large currents, an abrupt increase in a load connected to the device or a shortcircuiting of the load can result in large currents in excess of the rated current of the device flowing through the device, thereby creating a danger that the device will become excessively heated and, in an extreme case, that the device will be destroyed. To protect a power device against such thermal destruction, the temperature of the power device is constantly monitored and, when the temperature of the device exceeds a predetermined temperature or an overheating of the device is detected, some protection action is taken, for example, the power device is turned-off.

In monitoring a power IC, it is preferable to fabricate an overheating detection circuit including a temperature sensor into a substrate in which the power IC is formed in order to improve temperature sensitivity and to simplify the circuit arrangement. Typically, however, discrete elements have been used for forming a circuit which stops an operation of a power device upon detection of eddy currents or an overheating of the power device. In connection with this, a thermal sensor using a bipolar transistor as a thermo-sensitive sensor is described in E. Habekotté, Bull, ASE/UCS 76 (1985), 9mars, pp. 272-276.

From RCA Technical Notes 1270, 2 March 1981, pages 1 to 3 "Thermal Shutdown Circuitry" by 0.H. Schade, a protection circuit for reducing the on-chip power dissipation when the chip temperature exceeds a predetermined threshold is known. The circuit comprises a detector element, implemented as a reverse biased diode for generating a leakage current which is strongly dependent on the junction temperature of the diode. The leakage current is amplified by a reasonable number of current mirror amplifiers which may be connected in cascade. The final amplifier stage comprises a transistor and a resistor which is connected between the base and emitter terminals of the transistor. When the current amplified by the cascade-connected current mirror amplifiers generates a potential across the resistor that exceeds the base-emitter threshold potential of the transistor in the final amplifier stage, same causes to disable a utilization circuitry thereby substantially reducing power dissipation on the chip.

EP-A-240807 discloses a circuit for detecting an excessive temperature of power semiconductor elements. The circuit comprises a bipolar transistor having its base terminal open and in thermal contact with the element to be monitored. The bipolar transistor is connected in series with a depletion-MOSFET transistor for generating a constant current which is larger than the leakage current produced by the bipolar transistor under normal temperature conditions. If the temperature rises, the leakage current of the bipolar transistor increases expotentially until it reaches the constant current provided by the depletion-MOSFET. As a consequence thereof the internal resistance of the depletion-MOSFET rises sharply and the potential at the connection node between the two transistors is suddenly increased. This signal may be detected from an element which detects rise of said potential.

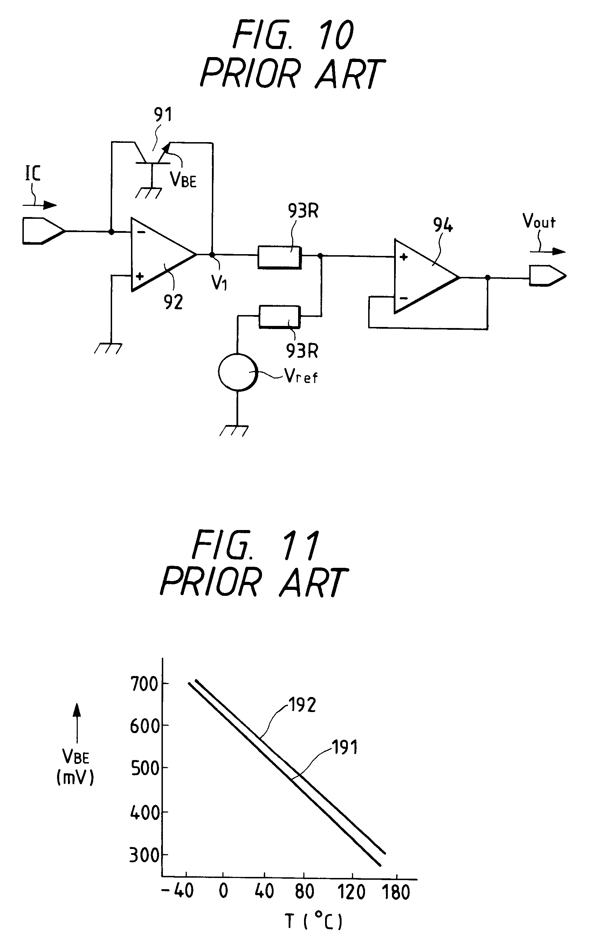

Fig. 10 illustrates a circuit arrangement of an overheating detection circuit of the prior art which uses the thermal sensor described in the above-cited reference. As shown in Fig. 10, a bipolar transistor 91, operating as a thermal sensor, is inserted into a feedback loop of an operational amplifier 92. An external constant current source (not shown) supplies a collector current I_{C} to the transistor 91. The operational amplifier 92 produces an output voltage V₁, which is equal in amplitude but of reverse polarity to a base-emitter voltage V_{BE} of the transistor 91. As shown in Fig. 11, the base-emitter voltage V_{BE} varies linearly with and is inversely proportional to temperature T. By properly amplifying the output voltage V₁ of the operational amplifier 92 by another operational amplifier 94, an output voltage Vₒᵤₜ which varies linearly with respect to temperature T can be obtained.

A feature of the above thermal sensor is that the output voltage Vₒᵤₜ varies linearly with respect to changes in temperature, and that little error exists over a broad range of temperature change. However, when the thermal sensor is assembled, for example, into a power IC as an overheating detection circuit, one will encounter various problems. Because the circuit of Fig. 10 uses a constant voltage circuit with less temperature dependency and a comparator for comparison with the output voltage Vₒᵤₜ, a large scale of circuitry is required for the thermal sensor. Further, it is necessary to minimize the temperature dependency of the operational amplifiers 92 and 94, as well as a reference voltage source V_{ref}. Otherwise, an error arising from the large temperature dependency of each of these components will greatly and adversely influence a detected temperature. To remove the adverse influence, most of the circuitry except the bipolar transistor 91 is fabricated and contained in a separate package which is placed at a location such that it is not influenced by the temperature of the power IC. Accordingly, when fabricating the circuit into a power IC package, it is necessary to solve the problems associated with the substrate temperature and the increased size of the circuit.

The conventional thermal sensor provides an output signal which varies linearly over a broad range of temperature changes. To the contrary, the conventional overheating detection circuit is designed such that when the temperature of a power device reaches approximately 150-180°C, it determines that the device temperature has reached an overheating temperature, and produces an output signal. Therefore, the overheating detection circuit must produce an output signal which must vary greatly in accordance with a relatively small temperature range. Thus, the performance requirements of the conventional thermal sensor and overheating detection circuit are quite different from each other.

The object underlying the present invention is to provide an improved overheating detection circuit which accurately detects overheating and is simple in structure.

This object is solved by an overheating detection circuit comprising the features of patent claim 1.

Preferred embodiments are subject to various dependent claims.

The accompanying drawings, which are incorporated in and constitute a part of the specification, illustrate presently preferred embodiments of the invention and, together with the detailed description of the preferred embodiments given below, serve to explain the principles of the invention. In the drawings:
Fig. 1 is a graph showing reverse leakage current versus temperature characteristic curves useful in explaining the principle of the present invention;
Fig. 2 is a circuit diagram of an overheating detection circuit in which the present invention can be implemented,
Fig. 3 is a graph useful in explaining an operation of the circuit shown in Fig. 2;
Fig. 4 is a circuit diagram of an overheating detection circuit in which the present invention can be implemented,
Fig. 5 is a timing chart useful for explaining an operation of the overheating detection circuit of Fig. 4;
Fig. 6 is a sectional view showing a structure of a junction of the overheating detection circuit according to the present invention,
Fig. 7 is a sectional view showing a structure of an example junction, which is illustrated as a vehicle for comparison;
Fig. 8 is a graphical representation of variations of a reverse leakage current of the PN junction versus voltage;
Fig. 9 is a sectional view of a key portion of a modification of the structure of Fig. 6;
Fig. 10 is a circuit diagram showing a conventional overheating detection circuit;
Fig. 11 is a graph showing V_{BE} versus temperature characteristic curves useful for explaining the principle of the conventional overheating detection circuit of Fig. 10.

Reference will now be made in detail to the presently preferred embodiments of the invention as illustrated in the accompanying drawings, in which like reference characters designate like or corresponding parts throughout the several drawings.

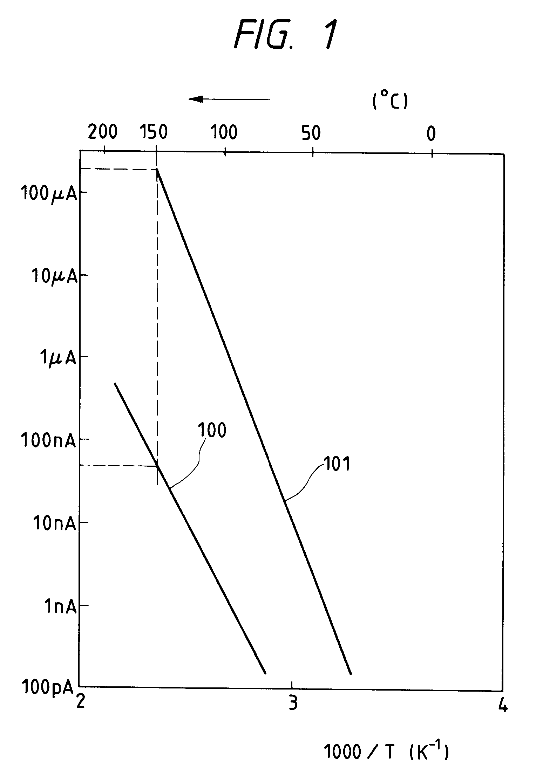

Fig. 1 is a graph showing characteristic curves of the temperature dependency of the reverse leakage current of the PN junction, and the temperature dependency of an output current of the bipolar transistors. In Fig. 1, curve 100 depicts a variation of the reverse leakage current of the PN junction with respect to a reciprocal of absolute temperature. As seen, the reverse leakage current I_{L} varies linearly with and is inversely proportional to the reciprocal of the absolute temperature (i.e., variation of the reverse leakage current is positive against temperature), and it has a large temperature dependency. This fact implies that it is possible to detect an overheating of a power IC formed on a substrate in which the PN junction or a thermal sensor is also formed, by making use of this great temperature dependency. However, in the temperature range of 150-180°C, which must be monitored, the reverse leakage current I_{L} is weak, for example, 70nA at 150°C. Therefore, it is difficult to read this leakage current exactly. It is important to note the fact that an amplification factor of the bipolar transistor also has a positive temperature dependency, an amplifier circuit including a plurality of stages of bipolar transistors is fabricated into the substrate of the power IC in order to amplify the weak leakage current. With this, an output current I_{E}, having a temperature dependency greater than that of the leakage current I_{L}, can be obtained as indicated by curve 101. An experiment showed that 100»A or more of output current was measured at 150°C.

The amplified leakage current I_{E} is converted into a voltage by making use of static characteristics of a depletion MOSFET (metal oxide semiconductor field effect transistor), for example, as a constant current circuit. In other words, the current I_{E} in the detection temperature range is converted into a voltage signal having a greater temperature dependency. Check is made as to whether or not the converted voltage signal is within the overheating temperature range by using a buffer having a threshold value. When the voltage signal reaches the overheating temperature range, the buffer produces a 2-value signal. A protection measure against thermal destruction of the power IC can be taken in which a load connected to the power IC is turned-off in accordance with the 2-value signal.

A preset temperature range may be set between the transmission and stop of a signal reporting an overheating temperature by combining two overheating detection circuits each having a distinct detection temperature level, and a hysteresis circuit. An arrangement of such a combination prevents the repetitive outputting of the report signal when a load, for example, changes and, consequently, temperature fluctuates in the power IC. Otherwise, such a temperature fluctuation can be mistaken as an overheating of the power IC, and the load will be erroneously disconnected from the power IC. Accordingly, the combination arrangement provides reliable overheating detection while eliminating the mistaken recognition.

When the overheating detection circuit is fabricated into a semiconductor integrated circuit having a high voltage power source, such as a power IC, the reverse biased power source voltage applied to the PN junction is also high. This high voltage extends the depletion layer of the PN junction such that the PN junction no longer functions as an ideal diode. More specifically, the excessively extended depletion layer greatly deviates a characteristic curve representative of a variation of the reverse leakage current at the PN junction from that of an ideal diode. In this case, a depletion layer should be formed near the PN junction to extend under an interconnection wiring layer. Such an extension of the depletion layer can be prevented by forming a conductive layer, such as a channel stopper, in the semiconductor substrate underlying the wiring layer such that it is coupled with the power source voltage thereby shutting off the depletion layer. With such a structure, unnecessary increases of the reverse leakage current and consequent mistaken detection of temperature can be eliminated thereby providing reliable overheating detection.

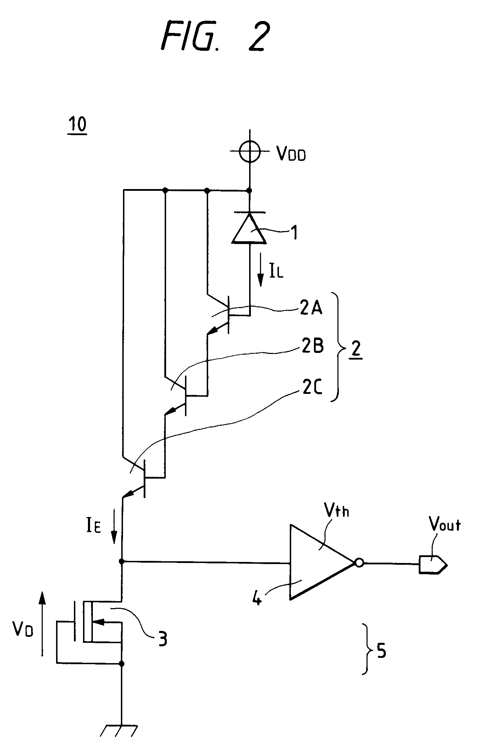

As shown in Fig. 2, the overheating detection circuit is formed in the same semiconductor substrate as that of the power IC. In the figure, reference numeral 1 designates a PN junction diode to which a reverse bias voltage V_{DD} is applied. A reverse leakage current I_{L} from the diode is amplified by a 3-stage amplifier 2, which is made up of three NPN bipolar transistors 2A, 2B, and 2C. The amplified reverse leakage current I_{E} is derived from the emitter of the NPN transistor 2C. Reference numeral 3 designates a constant current circuit comprising a depletion type MOSFET having its drain connected to the emitter of the NPN transistor 2C. The MOSFET 3 converts the current I_{E} in the vicinity of a detection temperature into a voltage signal V_{D}, i.e., a potential drop cross the MOSFET 3, by making use of a static characteristic of a constant current region of the MOSFET 3. The voltage signal V_{D} is input to a buffer 4 comprising a large amplitude amplifier having a threshold voltage Vₜₕ. When the voltage signal V_{D} exceeds the threshold voltage Vₜₕ, i.e., when the temperature of the power IC is within an overheating temperature range, the buffer 4 outputs a 2-value signal. As shown in Fig. 2, the buffer 4 and the MOSFET 3 make up a determining circuit 5.

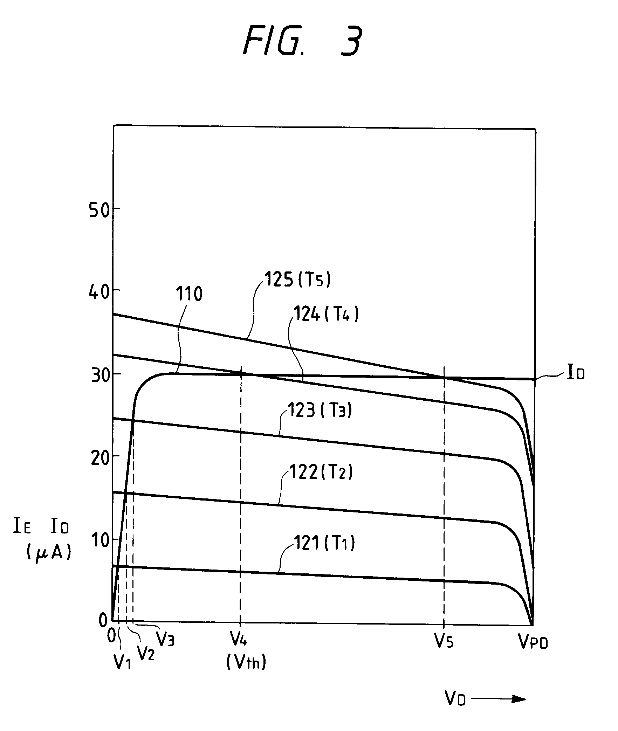

As shown in Fig. 3, a curve 110 designates a V_{D}- I_{D} characteristic curve representing a static characteristic of the MOSFET 3. Curves, 121-125 represent voltage characteristic curves of the amplified reverse leakage current I_{E} at temperatures T₁-T₅, respectively. As shown, when the drain voltage V_{D} is applied to the MOSFET 3 and gradually increased from zero, the drain current I_{D} sharply increases in the initial stage. When V_{D} exceeds a pinch-off voltage, the drain current I_{D} becomes stable at a constant current (30»A in this instance). As the temperature rises from T₁-T₅, the output emitter current I_{E} increases in such a way that the curves of the emitter current I_{E} at the respective temperature are substantially parallel one to another in their high current portions. In the overheating detection circuit of Fig. 2, the drain current I_{D} flowing into the MOSFET 3 is the same as the emitter current I_{E} of the NPN transistor 2C. Accordingly, a potential drop across the MOSFET 3 that is caused when the emitter current I_{E} flows through the MOSFET 3, viz., the drain voltage V_{D} of the MOSFET 3, is determined by points where the curve 110 intersects the curves 121-125 at the respective temperatures. In a region where the temperature of the power IC is low, i.e., at T₁, T₂, and T₃, the curves 121, 122, and 123 intersect the steeply rising portion of the curve 110, so that the leakage currents are converted into low drain voltages V₁ to V₃. In a region where the temperature is high, i.e., at T₄ and T₅, the curves 124 and 125 intersect a substantially constant current portion of the curve 110. Accordingly, the leakage current is converted into the drain voltages V₄ and V₅. Therefore, if the overheating detection circuit is arranged so that the temperatures T₄ and T₅ correspond to overheating detection temperatures, then a slight temperature change can be converted into a large voltage change in the overheating detection temperature range of T₄-T₅. More specifically, if the threshold value Vₜₕ of the buffer 4 is set at V₄, for example, when the drain voltage V_{D} of the MOSFET 3 exceeds the threshold voltage Vₜₕ, the buffer 4 produces a low level signal Vₒᵤₜ, which is the inversion of the drain voltage V_{D}. In this way, the circuit detects that the temperature of the power IC has reached the overheating temperature. The power IC can be protected from thermal destruction when the output signal Vₒᵤₜ of the buffer 4 is changed from a level "1" (high potential) to a level "0" (low potential) by turning-off the power IC in response to the level "0" output-signal.

In the circuit arrangement of Fig. 2, the overheating detection temperature can be set by properly selecting a junction area of the PN junction 1, a current amplification factor of the NPN transistor 2 as well as the number of amplifying stages comprising NPN transistor 2, a saturation current of the depletion type MOSFET 3, and the threshold voltage Vₜₕ of the buffer 4. Thus, the instant overheating detection circuit can be flexibly and exactly adjusted to detect overheating detection temperatures within a broad range of 50-200°C or more, for example.

As described above, the overheating detection circuit can be constructed with only six components. The overheating detection circuit thus constructed can convert a temperature dependency of the weak inverse leakage current of the PN junction into a large 2-value signal. Further, in manufacturing the overheating detection circuit, it can readily be formed in the same semiconductor substrate as that of the power IC. The reverse leakage current of the PN junction, which is weak but has a large temperature dependency, is amplified by utilizing a temperature dependency of the amplification factor of the NPN transistor. Still further, only the reverse leakage current corresponding to the overheating detection temperature range is converted into a large voltage change by utilizing a constant current characteristic of the depletion type MOSFET. This voltage change is further converted into an output signal by the buffer with the threshold voltage. Thus, the circuit successfully solves the technically difficult problem of processing the weak reverse leakage current of the PN junction, and accurately detects an overheating temperature.

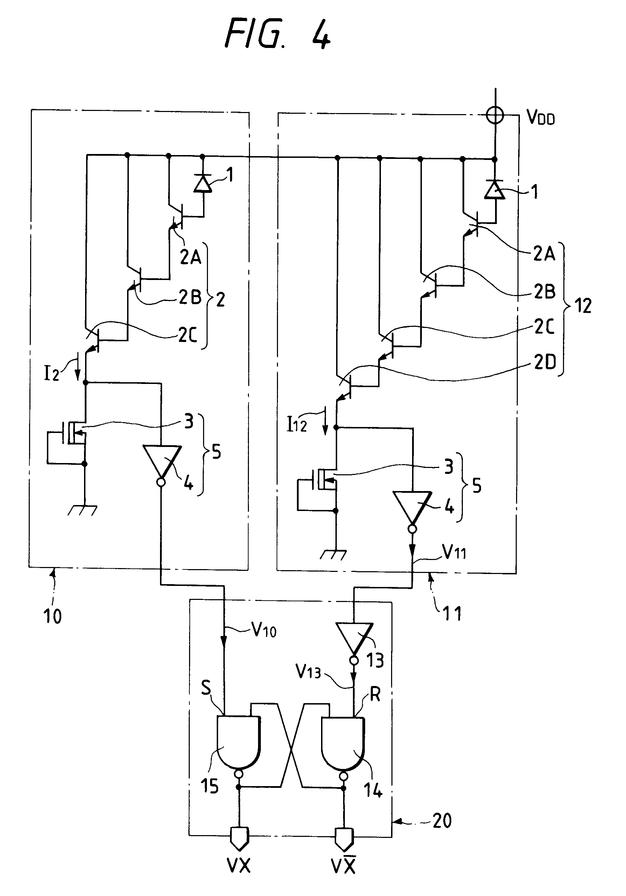

As shown in Fig. 4, a second example for an overheating detection circuit in which the present invention can be implemented comprises a first detector 10 having a circuit arrangement resembling that of the first embodiment, a second detector 11 having a 4-stage amplifier 12 including an NPN transistor 2D in addition to the NPN transistors 2A, 2B, and 2C of the circuit shown in Fig 2, and a hysteresis circuit 20 for receiving output signals V₁₀ and V₁₁ of the first and second detectors 10 and 11. The hysteresis circuit 20 comprises an inverter 13 for inverting the output signal V₁₁ of the second detector 11, and NAND gates 14 and 15 coupled with each other in a feedback manner. The NAND gates 15 and 14 receive the output signal V₁₀ of the first detector 10 as a set signal, and an output signal V₁₃ of the inverter 13 as a reset signal, respectively, and output a composite signal VX and an inverted signal VX bar, respectively.

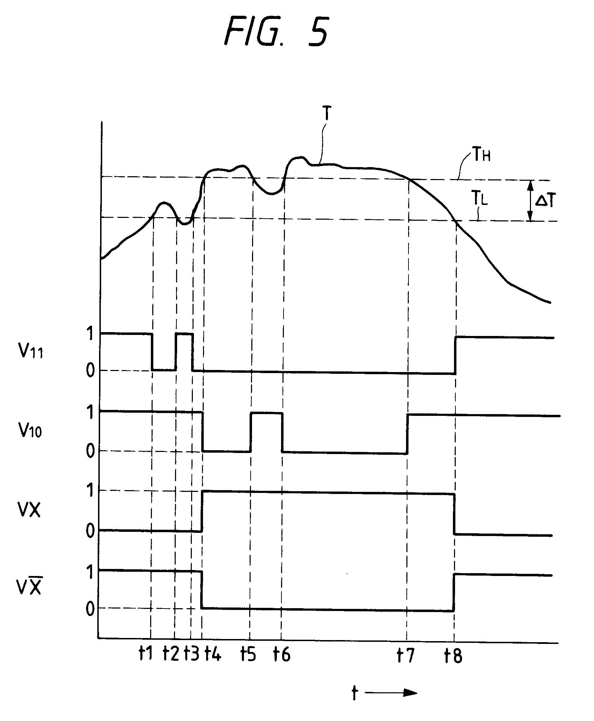

An operation of the overheating detection circuit shown in Fig. 4 will be described with reference to the timing chart shown in Fig. 5. A threshold value of the buffer 4 in the first and second detectors 10 and 11 is set to a value corresponding to an overheating detection temperature V_{H}. The emitter current I₁₂ of the 4-stage amplifier 12 in the second detector 12 is larger than the emitter current I₂ of the 3-stage amplifier 2 in the first detector 11 such that detecting temperature T_{L} of the second detector 12 is proportionally lower than that of the first detector 10. Accordingly, a temperature difference ΔT is produced between the detecting temperatures T_{H} and T_{L}, as shown in Fig. 5.

Assuming that the temperature T of a power IC varies as shown in Fig. 5, before the time t₁, the temperature T is below the temperature T_{L}, the output signals V₁₀ and V₁₁ of the first and second detectors 10 and 11 and are logic "1" (or high level), and the hysteresis circuit 20 is placed in a reset state, thereby producing the inverted output signal VX bar of logic "1" and the composite output signal VX of logic "0". At the time point t₁, the temperature T reaches the detecting temperature T_{L} wherein the second detector 11 detects the temperature T, and changes the logic level of its output signal V₁₁ from logic "1" to logic 0". The logic states of the output signals of the NAND gates 14 and 15, which receive the output signal V₁₁ of logic "0" through the inverter 13, remain unchanged. At time points t₂ and t₃, the temperature T drops below the detection temperature T_{L}. Also at this time, the logic states of the output signals VX and VX bar of the hysteresis circuit 20 are left unchanged, although the output signal V₁₁ changes its logic state.

At the time point t₄, the temperature T rises and reaches the overheating detection temperature T_{H} of the first detector 10. The first detector 10 changes the logic state of its output signal from logic "1" to logic "0". The NAND gates 14 and 15, when receiving it at the set terminal, change logical states of the output signals such that the output signal VX is set to logic "1" and the signal VX bar is set to logic "0". The changed logic states of the output signals VX and VX bar of the NAND gates 14 and 15 are maintained even at the time points t₅, t₆, and t₇ where the temperature T is below the detection temperature within the difference ΔT, and the output signal V₁₀ of the first detector 10 changes its logic state. At the time point t₈, the temperature T drops to the detection temperature T_{L}. The second detector 11 detects this and changes the logic state of its output signal to logic "1". At this time, the output signal VX goes low (logic "0"), and the inverted output signal VX bar goes high. Then, the hysteresis circuit 20 is again placed in the reset state.

As described above, in the overheating detection circuit, the two temperature detectors 10 and 11 have the two detection temperatures T_{H} and T_{L}, respectively, and, therefore, the preset temperature difference ΔT is provided. The hysteresis circuit 20 performs a hysteresis operation on the basis of the temperature difference ΔT. Therefore, irregular and short period variations in the temperature T of the power IC due to a variation of the load at temperatures near the overheating detection temperature, can be ignored as temperature noise. This fact implies that in an overheating state, the power IC can be stably held at off state in accordance with the output signal VX and the inverted output signal VX bar. With this feature, adverse effects due to unnecessary protection operations on the load circuit, and electromagnetic noise can be reduced. The resultant overheating protection function is reliable. To be more specific, let us consider a case that T_{H} = 170°C and T_{L} = 140°C, and the temperature of the power IC reaches an overheating temperature of 170°C. In this case, the protection function prohibits the power IC from being turned on until a temperature of the power IC drops to a temperature lower than 140°C where a satisfactory level of safety is guaranteed. In this respect, a very reliable overheating protection is realized.

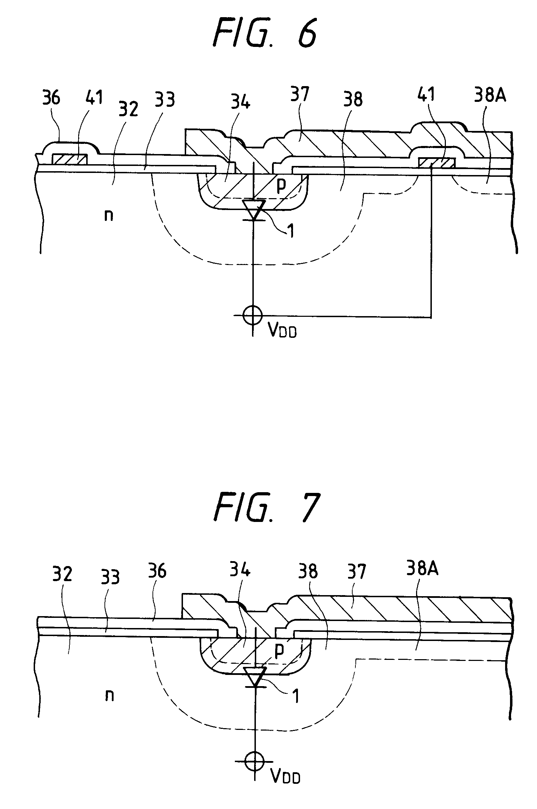

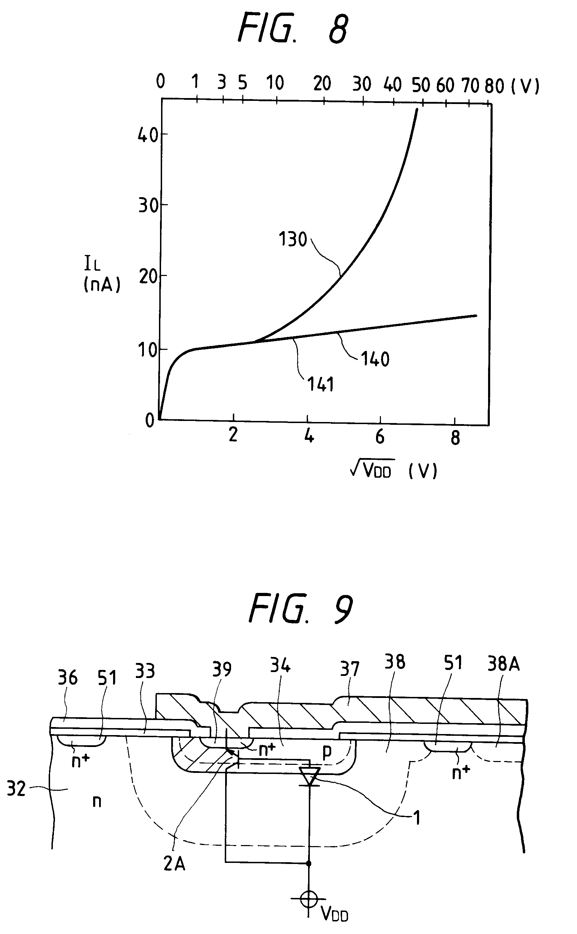

Fig. 6 is a sectional view showing a structure of a junction part of the overheating protection circuit according to the present invention. Fig. 7 is a sectional view showing a structure of the corresponding part of an example, which is illustrated as a vehicle for comparison. Fig. 8 is a graphical representation of variations of a reverse leakage current of the PN junction with respect to voltage. A PN junction 1, comprising a typical diode, which is illustrated as a vehicle for comparison in Fig. 7, is manufactured in the following manner. By using a window of an oxide film 33 formed on an N-type substrate 32, a P-type diffusion layer 34 is formed. Then, a phosphorus glass layer 36 is formed over the structure. Then, a window is opened in the phosphorus glass layer 36, and a metal wiring layer 37 is electrically connected to the P-type diffusion layer 34. When a reverse bias voltage V_{DD} is applied to the PN junction thus structured, a reverse leakage current I_{L} traces a curve 140 with respect to a square root of the bias voltage V_{DD}, as shown in Fig. 8, if the diode 1 is an ideal diode. More specifically, when the reverse bias voltage V_{DD} is applied across the PN junction, a depletion layer 38 is formed in the substrate side of the junction and a reverse leakage current I_{L}, which is proportional to a volume of the depletion layer, flows. The curve 140 tends to gently increase with respect to the reverse bias voltage V_{DD}. However, when the bias voltage V_{DD} exceeds a predetermined voltage, another depletion layer 38A is formed in the surface region of the N-type substrate right under the metal wiring layer 37. As a result, the volume of the depletion layer 38 increases and the leakage current I_{L} of the PN junction of the comparative example shown in Fig. 7 abruptly increases as indicated by a curve 130, which greatly deviates from the curve 140 of the ideal diode, and sharply rises as shown in Fig. 8. If such a diode is incorporated into the overheating detection circuit as shown in Fig. 2 or 4, the reverse leakage current I_{L} greatly changes when the reverse bias voltage V_{DD} changes. Thus, the overheating temperature detected is unreliable.

In the structure shown in Fig. 6, a poly silicon channel stopper 41 as a conductive layer is provided between the oxide film 33 and the phosphorus glass layer 36 beneath the metal wiring layer 37. The stopper 41 is set at the same potential as that of the N-type substrate 32, viz., potential V_{DD}. With this, the depletion layer 38A extending under the metal wiring layer 37 is cut off. As a result, an increase of the volume of the depletion layer 38 is restricted so that, as shown in Fig. 8, a curve 141, representative of the voltage dependency of the reverse leakage current I_{L}, substantially overlaps with the ideal curve 140. When the reverse bias voltage V_{DD} is set at 32V, for example, a variation of a detection temperature by the circuit of Fig. 2 can be reduced within 5°C.

Turning now to Fig. 9, there is shown a sectional view of a key portion of a modification of the structure of Fig. 6. In the structure, a P-type diffusion layer 34 formed in an N-type substrate 32 and an n+ diffusion layer 39 form a PN junction. An NPN transistor 2A is provided. For those elements, an n+ diffusion channel stopper 51 is formed in the surface region of the N-type substrate 32 beneath the metal wiring layer 37. As in the structure of Fig. 6, the depletion layer 38A extending under the metal wiring layer 27 is cut off by the n+ diffusion channel stopper 51. As a result, the voltage dependency of the volume of the depletion layer 38 is restricted and a curve of the reverse leakage current I_{L} of the PN junction 1 can be controlled so as to make it coincident with the ideal curve.

As shown in Fig. 9, the n⁺ diffusion channel stopper 51, together with the emitter of the first stage NPN transistor 2A, is formed in the P-type diffusion layer 34 in the same step of a manufacturing process, thereby forming a structure wherein the diode 1 as the PN junction and the NPN transistor 2A, as equivalently illustrated, are integrally assembled. Accordingly, the overheating detection circuit and the power IC can be formed in the same substrate and in the same process step. Therefore, manufacturing costs become low. The power voltage dependency of the emitter current of the NPN transistor 2A is also made weak, and hence the effects of the power voltage on the detection temperature are removed. Therefore, if the overheating detection circuit is connected to the same high voltage power source as that of the power IC, an accurate temperature detection can be secured in the overheating detection circuit.

As seen from the foregoing description, in an overheating detection circuit in which the present invention can be implemented, a reverse leakage current of a reversely biased PN junction is amplified to a predetermined level by bipolar transistors. The amplified reverse leakage current is converted into a potential drop across a constant current circuit in a determining circuit. A buffer with a threshold value converts the potential drop into a corresponding 2-value signal. The overheating detection circuit thus arranged is assembled into a substrate into which a power IC is assembled. By utilizing a large temperature dependency of the reverse leakage current of the PN junction diode and a temperature dependency of the amplification factor of the bipolar transistors, a signal corresponding to a temperature change of the power IC can be amplified to such a value as to allow its signal processing. Further, a leakage current corresponding to a temperature in the temperature region of detection overheating of the power IC can be converted into a large voltage change by utilizing a constant current region of a depletion type MOSFET as the constant current circuit. A temperature detection of the overheating detection circuit is very sensitive particularly in the temperature range of 150°-180°. In this performance, the overheating detection circuit is remarkably improved over the prior art. Only six components are required for forming the overheating detection circuit. The overheating detection circuit and the power IC are formed in the same substrate and in the same step. With these features, a small, inexpensive power IC having an overheating detection circuit can be provided.

In an overheating detection circuit comprising two detectors, each having a distinct detection temperature and a hysteresis circuit, the protecting function of the circuit may be inoperable for short period and small variations of temperature of the power IC near the detection temperatures, if the temperature difference ΔT between the different detection temperatures is appropriately selected. Therefore, adverse effects due to unnecessary repetition of the protecting operation, as well as electromagnetic noise caused by it can be eliminated. When an overheating temperature of a power IC is detected, the operation of the power IC is stopped and its restart is prohibited until it is confirmed that the overheating temperature detected drops to a temperature in a safety region which is ΔT lower than the detected temperature. Therefore, there is provided an overheating protecting circuit which is stably, reliably, and safely operable.

In an overheating detection circuit according to the present invention with such a structure that a channel stopper is provided just under the metal wiring layer to the PN junction or the NPN transistor, the depletion layer right under the PN junction is prevented from extending to under the wiring layer. Thus, the voltage dependency of the reverse leakage current of the PN junction and that of the emitter current of the NPN transistor is eliminated. Therefore, if an overheating detection circuit is formed in the same substrate as that of a high voltage power IC, a detection temperature is influenced little by the voltage dependency and the voltage variation. For example, if the power source voltage is set at 32V, a variation of the overheating detection temperature can be restricted within 5°C. Therefore, a power device, such as a power IC, containing such a reliable overheating detection circuit can be provided.

## Claims

1. An overheating detection circuit for detecting an overheating of a power integrated circuit, said power integrated circuit being formed in a substrate, said overheating detection circuit being disposed in said substrate and comprising:
a reversely biased junction (1) having a reverse leakage current (IL), said reverse leakage current being temperature dependent;
means (2, 2A, 2B, 2C) for amplifying said reverse leakage current; and
means (3, 4) for producing a voltage in accordance with said amplified reverse leakage current and for producing a signal when said voltage exceeds a threshold voltage to indicate that said power integrated circuit is overheated,
characterized by
means (41, 51) for limiting a volume of a depletion layer (38) of said junction (1), which limiting means comprises an additional layer (41, 51) to cut off an additional depletion layer (38A) extending in the surface region of the substrate, thereby controlling said temperature dependency of said reverse leakage current.

2. The overheating detection circuit of claim 1, wherein said junction (1) comprises a PN junction diode.

3. The overheating detection circuit of claims 1 or 2, wherein said means for limiting comprises a polysilicon layer (41).

4. The overheating detection circuit according to claims 1 or 2 wherein said means (51) for limiting comprises a semiconductor layer (51) with higher impurity concentration than that of the substrate.

5. The overheating detection circuit according to one of claims 1 to 4, wherein said means (2, 12) for amplifying comprises at least one transistor (2A, 2B, 2C, 2D).

6. The overheating detection circuit according to one of claims 1 to 5, wherein said means (5) for producing comprises a constant current circuit (3) for producing said voltage in accordance with said amplified reverse leakage current, and a buffer circuit (4) having said threshold voltage for producing said signal when said voltage exceeds said threshold voltage.

7. The overheating detection circuit of claim 6, wherein said constant current circuit (3) comprises a MOSFET.

8. The overheating detection circuit according to one of claims 1 to 7 further comprising:
first and second temperature detection circuits (10, 11), said first temperature detection circuit (10) having a first temperature threshold and said second temperature detection circuit (11) having a second temperature threshold lower than said first temperature threshold, and
hysteresis means (20) for receiving said signals (V ₁₀, V ₁₁) produced by said first and second temperature detecting circuits, for producing an overheating signal (VX) upon receipt of said signal produced by said first temperature detecting circuit (10) to indicate that said power integrated circuit is overheated, and for inhibiting the output of said overheating signal upon a receipt of said signal produced by said second temperature detecing circuit (11) after receipt of said signal produced by said first temperature detecting circuit (10) to indicate that said power integrated circuit is not overheated, said overheating detection circuit being disposed in said substrate (32).

9. The overheating detection circuit of claim 8, wherein said hysteresis means (20) comprises inverting means (13) for inverting said signal produced by said second temperature detecting circuit (11), and first and second NAND gates (14, 15).

10. The overheating detection circuit of claims 8 or 9, wherein said means (2, 12) for amplifying amplifies said reverse leakage current of said reversely biased junction (1) of said second temperature detection circuit (11) more than said reverse leakage current of said reversely biased junction of said first temperature detection circuit (10), and wherein said threshold voltage associated with said second temperature detection circuit (11) is substantially equal to said threshold voltage associated with said first temperature detection circuit (10).

## Patentansprüche

1. Schaltkreis zum Erfassen einer Überhitzung einer integrierten Leistungsschaltung, wobei die integrierte Leistungsschaltung auf einem Substrat ausgebildet ist und die Schaltung zum Erfassen der Überhitzung in dem Substrat angeordnet ist und umfaßt:
eine rückwärts gepolte Sperrschicht (1), die einen Leckstrom (IL) in Sperrichtung besitzt, wobei der Leckstrom in Sperrichtung temperaturabhängig ist,
eine Einrichtung (2, 2A, 2B, 2C) zum Verstärken des Leckstroms in Sperrichtung; und
eine Einrichtung (3, 4) zum Erzeugen einer Spannung in Übereinstimmung mit dem verstärkten Leckstrom in Sperrichtung und zum Erzeugen eines Signals, wenn die Spannung einen Schwellwert überschreitet, wodurch angezeigt wird, daß die integrierte Leistungsschaltung überhitzt ist,
**gekennzeichnet durch**
eine Einrichtung (41, 51) zum Begrenzen des Volumens einer Verarmungsschicht (38) der genannten Sperrschicht (1), wobei die Begrenzungseinrichtung eine zusätzliche Schicht (41, 51) aufweist zum Abschnüren einer zusätzlichen Verarmungsschicht (38A), die sich in den Oberflächenbereich des Substrats erstreckt, um dadurch die Temperaturabhängigkeit des Leckstroms in Sperrichtung in Abhängigkeit von der Temperatur zu steuern.

2. Schaltkreis zum Erfassen einer Überhitzung nach Anspruch 1, worin die Sperrschicht (1) eine PN-Sperrschichtdiode umfaßt.

3. Schaltkreis zum Erfassen einer Überhitzung nach Anspruch 1 oder 2, worin die Begrenzungseinrichtung eine Polysiliziumschicht (41) umfaßt.

4. Schaltkreis zum Erfassen einer Überhitzung nach Anspruch 1 oder 2, worin die Begrenzungseinrichtung (5) eine Halbleiterschicht (51) umfaßt mit einer höheren Verunreinigungskonzentration als diejenige des Substrats.

5. Schaltkreis zum Erfassen einer Überhitzung nach einem der Ansprüche 1 bis 4, worin die Verstärkungseinrichtung (2, 12) wenigstens einen Transistor (2A, 2B, 2C, 2D) umfaßt.

6. Schaltkreis zum Erfassen einer Überhitzung nach einem der Ansprüche 1 bis 5, worin die Erzeugungseinrichtung eine Konstantstromschaltung (3) umfaßt zum Erzeugen der Spannung in Übereinstimmung mit dem verstärkten Leckstrom in Sperrichtung, sowie eine Pufferschaltung (4), welche die Schwellspannung besitzt zum Erzeugen des Signals, wenn die Spannung die Schwellspannung überschreitet.

7. Schaltkreis zum Erfassen einer Überhitzung nach Anspruch 6, worin die Konstantstromschaltung (3) einen MOSFET umfaßt.

8. Schaltkreis zum Erfassen einer Überhitzung nach einem der Ansprüche 1 bis 7, weiterhin umfassend:
eine erste und zweite Temperaturerfassungsschaltung (10, 11), wobei die erste Temperaturerfassungsschaltung (10) einen ersten Temperaturschwellwert und die zweite Temperaturerfassungsschaltung (11) einen zweiten Temperaturschwellwert aufweist, der geringer als der erste Temperaturschwellwert ist, und
eine Einrichtung mit einer Hysterese (20) zum Empfang der Signale (V₁₀, V₁₁), die von der ersten und zweiten Temperaturerfassungsschaltung erzeugt werden, zum Erzeugen eines Überhitzungssignals (VX) im Ansprechen auf das Signal, welches von dem ersten Temperaturerfassungsschaltung (10) erzeugt wird, um anzuzeigen, daß der integrierte Leistungsschaltkreis überhitzt ist und zum Sperren der Ausgabe des Überhitzungssignals im Ansprechen auf das Signal, welches von der zweiten Temperaturerfassungsschaltung (11) erzeugt wird nach dem Empfang des Signals, welches von der ersten Temperaturerfassungsschaltung (10) erzeugt wird, um anzuzeigen, daß der integrierte Leistungsschaltkreis nicht überhitzt ist, wobei der Schaltkreis zum Erfassen einer Überhitzung in dem Substrat (32) angeordnet ist.

9. Schaltkreis zum Erfassen einer Überhitzung nach Anspruch 8, worin die Einrichtung mit einer Hysterese (20) einen Inverter (13) umfaßt zum Invertieren des Signals, welches von der zweiten Temperaturerfassungsschaltung (11) erzeugt wird, sowie erste und zweite NAND-Torschaltungen (14, 15).

10. Schaltkreis zum Erfassen einer Überhitzung nach Anspruch 8 oder 9, worin die Verstärkungseinrichtung (2, 12) den Leckstrom in Sperrichtung der rückwärts gepolten Sperrschicht (1) des zweiten Temperaturerfassungsschaltung (11) stärker verstärkt als den Leckstrom in Sperrichtung der rückwärts gepolten Sperrschicht der ersten Temperaturerfassungsschaltung (10) und worin die der zweiten Temperaturerfassungsschaltung (11) zugeordnete Schwellspannung im wesentlichen gleich der der ersten Temperaturerfassungsschaltung (10) zugeordneten Schwellspannung ist.

## Revendications

1. Un circuit de détection d'échauffement excessif destiné à détecter un échauffement d'un circuit intégré de puissance, ce circuit intégré de puissance étant formé dans un substrat, le circuit de détection d'échauffement excessif étant disposé dans ce substrat, et comprenant : une jonction (1) polarisée en inverse, ayant un courant de fuite inverse I_{L}), ce courant de fuite inverse dépendant de la température ;
des moyens (2, 2A, 2B, 2C) pour amplifier le courant de fuite inverse ; et
des moyens (3, 4) pour produire une tension conformément au courant de fuite inverse amplifié, et pour produire un signal lorsque cette tension dépasse une tension de seuil, pour indiquer que le circuit intégré de puissance présente un échauffement excessif,
caractérisé par
des moyens (41, 51) pour limiter le volume d'une couche de désertion (38) de la jonction (1), ces moyens de limitation comprenant une couche supplémentaire (41, 51) qui est destinée à supprimer une couche de désertion supplémentaire (38A) qui s'étend dans la région de surface du substrat, pour maitriser ainsi la dépendance du courant de fuite inverse vis-à-vis de la température.

2. Le circuit de détection d'échauffement excessif de la revendication 1, dans lequel la jonction (1) est formée par une diode à jonction PN.

3. Le circuit de détection d'échauffement excessif des revendications 1 ou 2, dans lequel les moyens de limitation comprennent une couche de silicium polycristallin (41).

4. Le circuit de détection d' échauffement excessif selon les revendications 1 ou 2, dans lequel les moyens de limitation (51) comprennent une couche de semiconducteur (51) ayant une concentration en impureté supérieure à celle du substrat.

5. Le circuit de détection d'échauffement excessif selon l'une des revendications 1 à 4, dans lequel les moyens d'amplification (2, 12) comprennent au moins un transistor (2A, 2B, 2C, 2D).

6. Le circuit de détection d'échauffement excessif selon l'une des revendications 1 à 5, dans lequel les moyens (5) destinés à produire une tension comprennent un circuit à courant constant (3) pour produire cette tension conformément au courant de fuite inverse amplifié, et un circuit amplificateur-séparateur (4) ayant la tension de seuil précitée, pour produire le signal précité lorsque la tension dépasse la tension de seuil.

7. Le circuit de détection d'échauffement excessif de la revendication 6, dans lequel le circuit à courant constant (3) comprend un transistor à effet de champ MOS.

8. Le circuit de détection d'échauffement excessif selon l'une des revendications 1 à 7, comprenant en outre :
des premier et second circuits de détection de température (10, 11), le premier circuit de détection de température (10) ayant un premier seuil de température et le second circuit de détection de température (11) ayant un second seuil de température, inférieur au premier seuil de température, et
des moyens d'hystérésis (20) qui sont destinés à recevoir les signaux (V₁₀, V₁₁) qui sont produits par les premier et second circuits de détection de température, à produire un signal d'échauffement excessif (VX) sous l'effet de la réception du signal qui est produit par le premier circuit de détection de température (10), pour indiquer que le circuit intégré de puissance présente un échauffement excessif, et à inhiber l'émission du signal d'échauffement excessif sous l'effet de la réception du signal qui est produit par le second circuit de détection de température (11), après la réception du signal qui est produit par le premier circuit de détection de température (10), pour indiquer que le circuit intégré de puissance ne présente pas un échauffement excessif, le circuit de détection d'échauffement excessif étant disposé dans le substrat précité (32).

9. Le circuit de détection d'échauffement excessif de la revendication 8, dans lequel les moyens d'hystérésis (20) comprennent des moyens inverseurs (13) pour inverser le signal qui est produit par le second circuit de détection de température (11), et des première et seconde portes NON-ET (14, 15).

10. Le circuit de détection d'échauffement excessif des revendications 8 ou 9, dans lequel les moyens d'amplification (2, 12) amplifient le courant de fuite inverse de la jonction (1) polarisée en inverse du second circuit de détection de température (11) davantage que le courant de fuite inverse de la jonction polarisée en inverse du premier circuit de détection de température (10), et dans lequel la tension de seuil qui est associée au second circuit de détection de température (11) est pratiquement égale à la tension de seuil qui est associée au premier circuit de détection de température (10).
